# EUROPEAN PATENT SPECIFICATION

(11) **EP 3 657 907 B1**
(45) Date of publication and mention of the grant of the patent: **07.10.2020**
(21) Application number: 19202656.5
(22) Date of filing: 11.10.2019
(51) Int. Cl.: H05B 6/68, H05B 6/70

(54) **SOLID-STATE COOKING APPARATUS**
FESTKÖRPERKOCHVORRICHTUNG
APPAREIL DE CUISSON À SEMI-CONDUCTEURS

(30) Priority: 23.11.2018 NL 2022064
(43) Date of publication of application: 27.05.2020
(73) Proprietor: Ampleon Netherlands B.V., 6534 AV Nijmegen (NL)
(72) Inventor: Tymofieiev, Yevhen, 6534 AV Nijmegen (NL)
(74) Representative: Jacobs, Bart

(56) References cited:
- EP-A1- 2 182 774
- EP-A1- 2 953 425
- EP-A1- 3 136 001
- JP-A- 2009 301 747
- US-A- 5 961 871

## Description

The present invention relates to a solid-state cooking apparatus. The present invention further relates to a field applicator for applying an electromagnetic wave, preferably to a cooking cavity of a solid-state cooking apparatus.

Conventional cooking apparatuses based on magnetrons, the so-called microwave ovens, are more and more replaced by solid-state cooking (SSC) apparatuses. In these devices, the power generating element is not formed by a magnetron but by a semiconductor-based radiofrequency (RF) power amplifier (PA) system. These PA systems comprise power amplifiers. Examples of such amplifiers are Silicon-based laterally diffused metal-oxide semiconductor (LDMOS) amplifiers or Gallium Nitride field-effect transistors (FETs).

In solid-state cooking systems, the input return losses of the cooking cavity can be poor due to the unpredictable loading. Different types and amounts of food need to be cooked in domestic applications. In addition, the RF properties of the food are constantly changing during the cooking process, for example due to changing water content. Furthermore, the cooking cavity can be loaded with highly reflective materials such as metal pans, pots, possibly by accident.

The RF performance of the PA depends on the output load that is presented at the output of the amplifier. Usually, a PA is tuned to deliver the best performance with a frequency-independent load, most often 50 Ohm. However, in practice, during cooking, the effective load seen by the PA will deviate strongly from this nominal impedance. This mismatch results in degraded efficiency and output power, and may even result in damage to the PA or other components used in the amplifying path.

To prevent damage to the PA during use, the known SSC systems are equipped with ferrite circulators or isolators. These elements redirect power reflected from the cooking cavity into a load where it can be dissipated. The main drawbacks of the circulator are additional losses, increased costs, and a low reliability at high power levels.

EP 2 182 774 A1 discloses a solid-state cooking apparatus according to the preamble of claim 1. A further solid-state cooking apparatus is known from EP 3 136 001 A1.

An object of the present invention is to provide a solid-state cooking apparatus in which at least some of the problems mentioned above are at least partially alleviated.

This object is achieved with the solid-state cooking apparatus as defined in claim 1, which comprises a cooking cavity, a power amplifier system for generating a radiofrequency 'RF' signal, and a field applicator configured to provide an electromagnetic wave into the cooking cavity based on the generated RF signal.

The field applicator comprises a splitting element for splitting the generated radiofrequency signal into a first signal and a second signal, a first antenna element for emitting a first wave based on the first signal into the cooking cavity, and a second antenna element for emitting a second wave based on the second signal into the cooking cavity.

The first and second waves are preferably each linearly polarized electromagnetic waves. The first and second linearly polarized electromagnetic waves preferably form, together and in the cooking cavity, a circularly or elliptically polarized electromagnetic wave. A circularly polarized wave is preferably formed but small to larger deviations in amplitude or phase relationship between the first and second signals may result in elliptically polarized electromagnetic waves.

The splitting element comprises a quadrature coupler having an input port connected to the power amplifier system, an isolated port connected to a predefined load, a first output port connected to the first antenna element, and a second output port connected to the second antenna element. Furthermore, the solid-state cooking apparatus is operable in at least one of a first mode and second mode, wherein, in the first mode, the predefined load equals an RF short or an RF open, and, in the second mode, the predefined load equals a dummy load configured to dissipate the signal received at the isolated port of the quadrature coupler.

The quadrature coupler is configured so that a signal input to one port among the input port and the isolated port is split into two signals emerging at the first and second output ports and which are 90 degrees apart in phase. Similarly, a signal input to one port among the first output port and the second output port is split into two signals emerging at the input and isolated ports and which are 90 degrees apart in phase. A particular example of a quadrature coupler is a 3dB hybrid coupler in which the signal is equally split. Further or other types of quadrature couplers include branch-line couplers, Lange couplers, waveguide couplers, substrate integrated waveguide (SIW) couplers, and overlay couplers.

Typically, the quadrature coupler is designed using transmission lines having a particular characteristic impedance. The predefined load, when intended to dissipate the power emerging at the isolated port, may have an impedance that is equal to this characteristic impedance. On the other hand, when the predefined load is intended to reflect the power emerging from the isolated port back into the quadrature coupler, the load may be an RF short or an RF open. Here, it is noted that in practical situations a true short or open does not exist at RF frequencies. Rather, the RF open should be considered as being a large, mostly capacitive, impedance that causes a large reflection at the isolated port - predefined load interface. Similarly, the RF short should be considered as being a small, mostly inductive, impedance that causes a large reflection at the isolated port - predefined load interface.

The apparatus may further comprise a switching unit that connects one of the RF short, the RF open, or the dummy load to the isolated port of the quadrature coupler. The apparatus may additionally comprise a controller for controlling the switching unit in dependence of a desired operating mode of the solid-state cooking apparatus. The controller can be configured to control the switching unit based on one or more parameters that have been determined using measurements. For example, the switching unit can be controlled based on a measured voltage, current, power, and/or impedance.

The solid-state cooking apparatus may be equipped with a power estimating system that comprises one or more power estimating units that estimate an amount of power. This amount of power may be related to the power that is reflected back from the cooking cavity and that is received at the first and/or second output port. Alternatively, the power estimating unit(s) is/are configured to determine the power that is dissipated in or reflected by the predefined load, or the power that is outputted by the power amplifier system. Based on the estimated power(s) the controller may control the switching unit.

The controller may be configured to switch the operating mode from the first mode to the second mode when at least one of the estimated power(s) exceeds a first threshold. Additionally or alternatively, the controller may be configured to switch the operating mode from the second mode to the first mode when at least one of the estimated power(s) is below a second threshold. The second threshold may be set lower than the first threshold to prevent excessive switching.

For example, the controller may be configured to switch the operating mode from the first mode to the second mode when the power reflected back from the cooking cavity and received at the first and/or second output ports and/or the power reflected by or dissipated in the predefined load exceeds a first threshold. The different determined power levels may each be compared to a respective threshold. Alternatively, the different determined power levels are combined into a single value which is then compared to a first threshold.

Alternatively, the controller may be configured to switch the operating mode from the second mode to the first mode when the power reflected back from the cooking cavity and received at the first and/or second output ports and/or the power reflected by or dissipated in the predefined load is below a second threshold.

The first threshold may be set in such a manner that when the reflected power becomes too high, possibly causing dangerous conditions for the power amplifier system, the switch to the second mode is made to allow the reflected power to be dissipated. On the other hand, the second threshold may be set in such a manner that when the reflected power is low, the switch to the first mode is made. In this mode, the reflected power is re-inserted into the cavity, thereby improving cooking and/or system efficiency.

To perform the power measurement function, the power estimating units may each comprise a directional coupler, preferably a bi-directional coupler. Additionally or alternatively, the power dissipated in the dummy load may be determined using a voltage or current meter attached to the dummy load. In another example, the power outputted by the power amplifier system is determined based on the DC power dissipated in the power amplifier system, or power amplifier in that power amplifier system, and the temperature of the system or amplifier. For example, the outputted RF power can be computed by subtracting the dissipated power from the inputted DC power, wherein the dissipated power is calculated based on the measured temperature.

Each of the power estimating units may be arranged a) between the first output port and the first antenna element, or b) between the second output port and the second antenna element, or c) between the isolated port and the predefined load.

At least one power estimating unit may be configured to determine a power dissipated in the dummy load, wherein the at least one power estimating unit comprises a current or voltage meter coupled to the dummy load.

At least one of the switching unit, the controller, and the power estimating units can be comprised in the field applicator.

The solid-state cooking apparatus may include a double input circular polarization antenna, in which the first and second antenna elements are comprised. Alternatively, the first and second antenna elements may be mutually orthogonal arranged antennas such as dipole antennas, folded dipole antennas, bowtie dipole antennas, loop antennas, slot antennas, patch arrays, waveguides with orthogonal probes, and spiral antennas.

The first and second antenna elements and the splitter can be realized using substrate integrated waveguide technology. For example, the field applicator may comprise a dielectric substrate that is covered on opposite sides, e.g. a top and bottom side, with a conductive layer, such as a metal layer. Here, the metal layer on the top side is usually patterned to define electrical tracks. The metal layer on the bottom side typically forms a ground layer. The substrate can be in the form of a printed-circuit board or laminated structure that may comprise one or more dielectric layers. In case the substrate comprises a plurality of dielectric layers, conductive layers may be arranged in between the dielectric layers.

A plurality of vias may be provided that extend through the substrate and that electrically connect the conductive layers on the opposite sides. The plurality of vias and the conductive layers define the splitting element and the first and second antenna element. More in particular, the plurality of vias, and the conductive layers on the opposite sides may form a dielectric filled waveguide element. Such element may for example be the splitting element, the first antenna element, or the second antenna element.

The present invention is not limited to substrate integrated waveguide technology. Other technologies for realizing the field applicator, such as a microstrip or strip line may also be used.

The power amplifier system may comprise a RF power amplifier package in which a RF power amplifier is accommodated or a semiconductor die on which a RF power amplifier is realized, wherein the RF power amplifier package or the semiconductor die is arranged on one of the opposite sides of the dielectric substrate.

The power amplifier system or parts thereof may be integrated into and/or arranged on the field applicator. For example, a power amplifier of the power amplifier system may be arranged in the field applicator. Furthermore, the field applicator may at least partially extend in the cooking cavity.

The solid-state cooking apparatus may additionally comprise a further power amplifier system for generating a further radiofrequency 'RF' signal, and a further field applicator configured to provide a further electromagnetic wave into the cooking cavity based on the generated further RF signal. In this case, the further power amplifier system and the further field applicator are configured to provide a further circularly or elliptically polarized electromagnetic wave into the cooking cavity that has a polarity that is opposite to the polarity of said circularly or elliptically polarized electromagnetic wave. Due to the opposite polarities, a wave generated by one field applicator and picked up by the other field applicator will in first instance not reach the power amplifier connected to the quadrature coupler of that field applicator. Rather, when the other field applicator is connected to a dummy load, the picked up wave will be dissipated. Accordingly, isolation between adjacent field applicators, or the power amplifiers connected to those field applicators can be improved.

The further field applicator may comprise a further splitting element for splitting the generated further radiofrequency signal into a third signal and a fourth signal, a third antenna element for emitting a third wave based on the third signal into the cooking cavity, and a fourth antenna element for emitting a fourth wave based on the fourth signal into the cooking cavity.

The further splitting element may comprise a further quadrature coupler having an input port connected to the further power amplifier system, an isolated port connected to a further predefined load, a first output port connected to the third antenna element, and a second output port connected to the fourth antenna element. In the first mode, the predefined load equals an RF short or an RF open, and, in the second mode, the predefined load equals a dummy load configured to dissipate the signal received at the isolated port of the further quadrature coupler. The third and fourth waves are each linearly polarized electromagnetic waves, said third and fourth linearly polarized electromagnetic waves together forming, in the cooking cavity, said further circularly or elliptically polarized electromagnetic wave.

The solid-state cooking apparatus may further comprise a further switching unit that connects one of the RF short, the RF open, or the dummy load to the isolated port of the further quadrature coupler, wherein the further switching unit is controlled by the controller. The RF open, RF short, or dummy load are preferable the same as their counterparts for the earlier mentioned field applicator.

More in particular, at least one of the further field applicator and the further power amplifier system is identical to said field applicator and said power amplifier system, respectively. Among adjacently arranged field applicators and further applicators everything can be identical apart from which port of the quadrature coupler the (further) power amplifier system and predefined load are connected to.

The present invention is not limited to two field applicators. Any number of field applicators could be arranged provided that adjacently arranged field applicators are configured to introduce electromagnetic waves into the cooking cavity with opposite polarities.

According to a further aspect, the present invention provides a field applicator as defined in claim 15.

Next, the present invention will be described in more detail referring to the appended drawings, wherein:
Figure 1 illustrates a known solid-state cooking apparatus;
Figure 2 schematically illustrates an embodiment of a field applicator in accordance with the present invention;
Figure 3 illustrates a microstrip implementation of (part of) the field applicator of figure 2;
Figure 4 illustrates a substrate integrated waveguide implementation of (part of) the field applicator of figure 2; and
Figure 5 illustrates a solid-state cooking apparatus in which two field applicators are arranged in the cooking cavity.

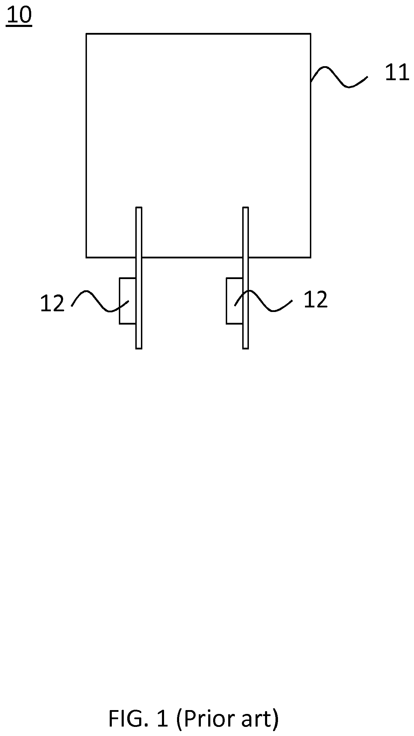

Figure 1 illustrates a known solid-state cooking apparatus 10. It comprises a cooking cavity 11, and one or more field applicators 12. Field applicators 12 comprise amplifying elements, or are connected to amplifying elements, such as RF amplifiers or RF amplifier systems. The signals amplified by these amplifiers are inserted by the field applicators into cooking cavity 11. To that end, field applicators 12 are equipped with one or more antennas.

It is a known problem that waves emitted by a field applicator 12 could be reflected off the metal walls of cooking cavity 11 and could be picked up by the antennas of field applicator 12. Another known problem is that not all of the available power is emitted into cooking cavity 11. Some of the power delivered to the antennas is reflected at the antenna back into the field applicator. A further problem exists in that a wave emitted by a first field applicator can be picked up by an adjacently arranged second field applicator.

Within the context of the present invention, the signals that are inserted back into the field applicator, whether it relates to signals reflected at the antenna, signals received from adjacent field applicators, or signals received as a consequence of reflection by the cooking cavity walls, will jointly be referred to as signals or waves received from the cooking cavity. The present invention particularly relates to signals received from the cooking cavity that are the consequence of reflection by the cooking cavity walls.

In short, the present invention proposes an approach by which the deteriorating effects of received signals or waves can be mitigated.

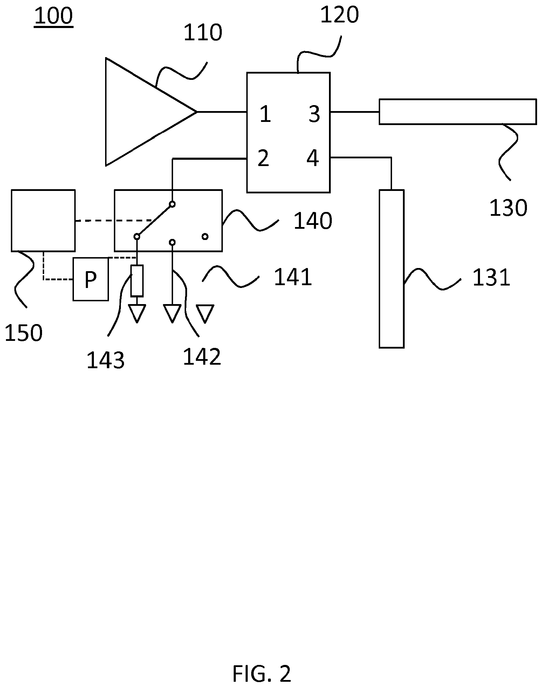

Figure 2 schematically illustrates an embodiment of a field applicator 100 in accordance with the present invention. This field applicator may for example be used in a solid-state cooking apparatus 10 shown in figure 1.

Field applicator 100 comprises an RF power amplifier system 110, which may be a balanced, or single-ended amplifier system, optionally based on a Doherty, push-pull or other type of amplifier. The output of amplifier system 110 is fed to an input port 1 of quadrature coupler 120. Isolated port 2 of coupler 120 is connected to a switching unit 140 which is able to connect isolated port 2 either to an RF open 141, an RF short 142, or a dummy load 143, such as 50 Ohm.

A first output port 3 of coupler 120 is coupled to a first antenna element 130, and a second output port 4 of coupler 120 to a second antenna element 130. The signals fed to first and second antenna elements 130, 131 differ in phase, for example by 90 degrees. Each of antenna elements 130, 131 emits a linearly polarized wave into cooking cavity 11. However, the phase difference between the signals provided to antenna elements 130, 131, optionally together with the orientation and/or positioning of the antenna elements 130, 131 results in the generation of a circularly, or at least substantially circularly, polarized wave being emitted in cavity 11. It should be noted that in figure 2, the phase difference between the signals inputted into the antenna elements 130, 131 is generated by coupler 120. More in a particular, the signal emerging at second output port 4 in response to a signal inputted at port 1 lags by 90 degrees relative to the signal emerging at first output port 3.

RF power amplifier system 110 may also be arranged outside of field applicator 100. In such case, field applicator 100 comprises a suitable connector for allowing the RF signal generated by RF power amplifier system 110 to be inputted into field applicator 100. Similarly, switching unit 140, controller 150, dummy load 143, RF open 141, RF short 142 may all or partially arranged outside field applicator 100.

Switching unit 140 is controlled by controller 150. In figure 2, a power estimating unit P is indicated that measures the power dissipated in dummy load 143. When dummy load 143 is purely resistive, power estimating unit P can embodied as a current or voltage meter. Controller 150 uses the estimated power to control switching unit 140 as will be described later.

It should be noted that power estimating unit P may be arranged at other positions even outside field applicator 100. For example, a power estimating unit may be arranged in between coupler 120 and one or more of the antenna elements 130, 131, in between isolated port 2 and switching unit 140, in between switching unit 140 and RF open 141, RF short 142, or predefined load 143, or in between power amplifier system 110 and input port 1. Consequently, power estimating unit P may be configured to determine the power that is reflected back from the cooking cavity and received at the first and/or second output port, and/or the power that is dissipated in or reflected by predefined load, and/or the power that is outputted by the power amplifier system. Controller 150 is configured to control switching unit 140 based on one or more of the estimated powers.

Next, the working principles of field applicator 100 will be explained in detail.

An RF signal generated by RF power amplifier system 110 is fed to input port 1 of coupler 120. This signal will at least substantially equally be split over first and second output ports 3, 4. Although the amplitudes of these signals are at least substantially equal, they differ in phase. More in particular, the signal outputted at port 4 lags by 90 degrees relative to the signal outputted at port 3. Next, these signals are fed to respective antenna elements 130, 131, which each will generate a linearly polarized electromagnetic wave. Due to the 90 degrees phase difference, these waves will combine into a circularly polarized wave. More in particular, antenna element 130 is configured to output a wave that is polarized in a first direction, and antenna element 131 will output a wave that is polarized in a second direction perpendicular to the first direction. Without loss of generality, it will be assumed that the circularly polarized wave corresponds to a right-hand circularly polarized wave.

Next, the situation will be described in which the circularly polarized wave is reflected by the cavity walls and is picked up by antenna elements 130, 131. Here, the signal picked up by antenna element 130 will be referred to as Vi_1 and the signal picked up by antenna element 131 as V2_i. As signals Vi_1 and Vi_2 correspond to the two linearly polarized components of the circularly polarized wave they have a 90 degrees phase difference. Due to the reflection, the orientation of the wave will have shifted from a right-hand to a left-hand orientation and the propagation direction will have been inverted. As a result, Vi_2 lags by 90 degrees relative to Vi_1.

Coupler 120 is symmetric in the sense that a signal inputted at port 3 will emerge at port 1 and at port 2, at least substantially equally split, wherein the signal at port 2 lags by 90 degrees relative to the signal at port 1. Similarly, a signal inputted at port 4 will emerge at port 1 and at port 2, at least substantially equally split, wherein the signal at port 1 lags by 90 degrees relative to the signal at port 2.

A signal Vi_1 at port 3 will result in a 3dB attenuated signal at port 1 and a 3dB attenuated signal at port 2 that lags the corresponding signal at port 1 by 90 degrees. Similarly, a signal Vi_2 at port 4 will result in a 3dB attenuated signal at port 2 and a 3dB attenuated signal at port 1 that lags the corresponding signal at port 2 by 90 degrees. As Vi_2 already lags 90 degrees with respect to Vi_1, the signals at port 1, i.e. the signals related to Vi_1 and Vi_2, will cancel each other whereas the signals at port 2 add in phase.

Depending on the load connected to isolated port 2 by switching unit 140, the signal at port 2 will either be reflected back into coupler 120, where it will result in a left-hand circularly polarized wave being emitted into cavity 11, or it will be absorbed in the load. The formed case occurs when the predefined load equals the RF short 142 or the RF open 141. The latter case occurs when the predefined load is a resistive dummy load 143.

By controlling switching unit 140 using controller 150, it becomes possible to either achieve improved stability and ruggedness, e.g. by allowing the signal to be dissipated in dummy load 143, or to improve overall efficiency of the system by allowing the signal, which would otherwise be lost, to be reflected, by RF open 141 or RF short 142, through coupler 120 back into cavity 11.

To control the switching process, controller 150 relies on power measurements or other measurements that are indicative of the power received from cavity 11 obtained from one or more power estimating units P as described above. The estimations and/or measurements are compared jointly or individually to one or more thresholds. Based on this or these comparison(s), controller 150 may decide to control switching unit 140 to switch between a first mode, in which RF open 141 or RF short 142 is connected to isolated port 2, and a second mode, in which dummy load 142 is connected to isolated port 2.

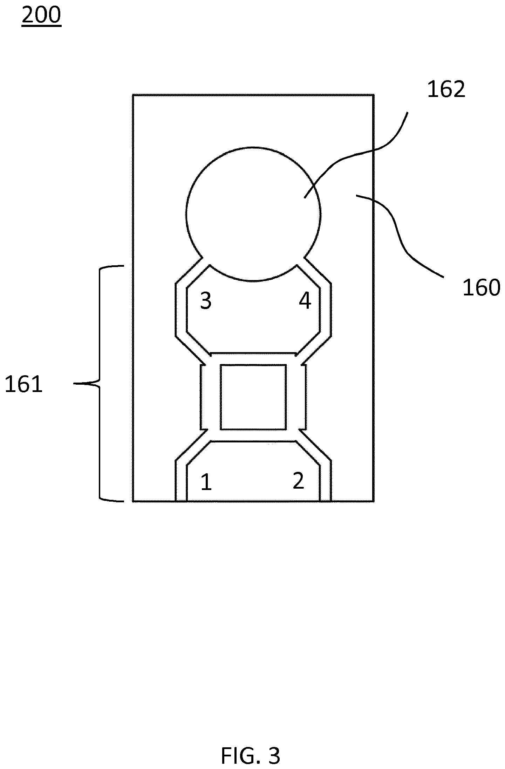

Figure 3 illustrates an example of a field applicator 200 in accordance with the present invention. This figure illustrates a microstrip implementation on a single or multiple layer printed-circuit board 160 or other substrate. It comprises a branch-line coupler 161 and a circular patch antenna 162 in which the first and second antenna elements are integrated.

In figure 3, the RF power amplifier system, controller, switching unit, and the various loads for connecting to isolated port 2 are not included in field applicator 200. In other embodiments, printed-circuit board 160 is larger and may also accommodate some or all of these components.

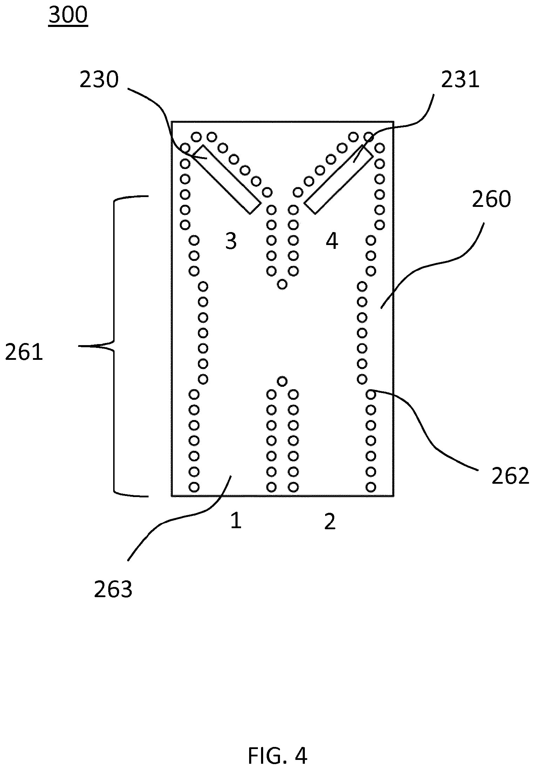

Figure 4 illustrates a substrate-integrated waveguide (SIW) implementation of a field applicator 300 that corresponds in terms of functionality to the embodiment in figure 3. Again, a single or multiple layer printed-circuit board 260 or other substrate is used. However, in this case, the top and bottom surfaces of printed-circuit board 260 are almost completely covered by a metal layer 263. In addition, two slots 230, 231 are arranged in metal layer 263. These slots optionally extend inside and/or through printed-circuit board 260 and/or the metal layer on the backside. Each slot 230, 231 forms a respective slot antenna.

A plurality of vias 262 connect the metal layers on both sides of printed-circuit board 260, thereby forming substrate integrated waveguide structures. For example, a dielectric filled waveguide component is formed in the shape of a 3dB hybrid coupler 261.

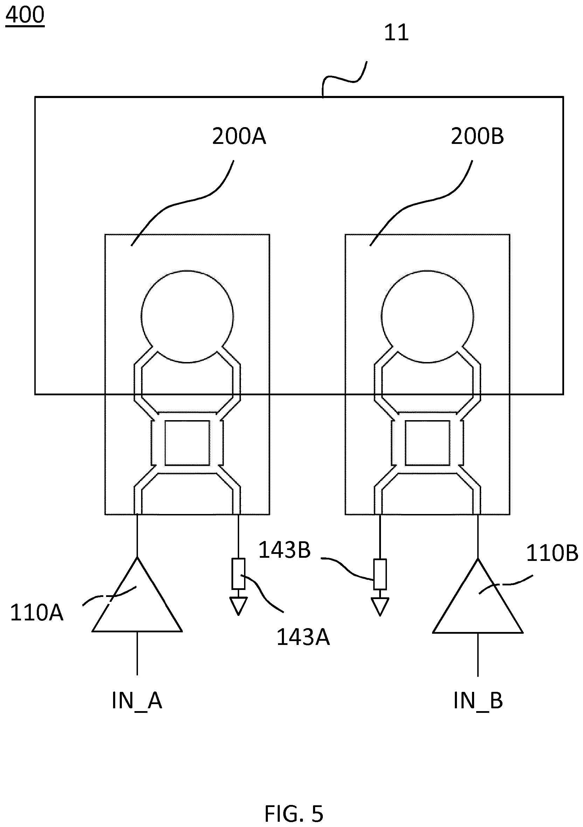

Figure 5 illustrates a solid-state cooking apparatus in which at least two field applicators 200A, 200B are arranged, preferably adjacently. In this embodiment, the field applicators apply electromagnetic waves into cavity 11 that have opposite polarity. In figure 5 this is achieved by having RF power amplifier 110A and dummy load 143A connected to different ports of the hybrid coupler of field applicator 200A when compared to RF power amplifier 110B and dummy load 143B. This will result in the polarity of the electromagnetic wave emitted by field applicator 110A being one of a right-hand polarization and a left-hand polarization, and the polarity of the electromagnetic wave emitted by field applicator 110B being the other of a right-hand polarization and a left-hand polarization. Consequently, when the wave generated by field applicator 200A is picked up by field applicator 200B, it will be dissipated in load 143B connected to field applicator 200B, and vice versa. Accordingly, by arranging field applicators in this manner, the isolation between adjacent field applicators can be improved.

The embodiment in figure 5 is not limited to using dummy loads as predefined loads. More in particular, the field applicators of figures 3 and 4 can equally be used. In addition, the concept of figure 2 can be applied for each field applicator separately. However, it is preferred if each field applicator is connected to one and the same of an RF open, RF short, and dummy load. It should be noted that the exact components values, e.g. resistance, inductance, or capacitance, for similar components for different field applicators may be different.

Further to the above, the signal provided to the inputs IN_A and IN_B of the different power amplifiers 110A, 110B may be the same signal or a separate signal.

In the above, the invention has been described using detailed embodiments thereof. The skilled person will however understand that the present invention is not limited to these embodiments. Instead, several modifications are possible without deviating from the scope of the invention which is defined in the appended claims.

### List of reference numbers

- P: power estimating unit
- 1: input port
- 2: isolated port
- 3: first output port
- 4: second output port
- 10: solid-state cooking apparatus
- 11: cooking cavity
- 12: field applicator
- 100: field applicator
- 110, 110A, 110B: RF amplifier
- 120: quadrature coupler
- 130: first antenna element
- 131: second antenna element
- 140: switching unit
- 141: RF open
- 142: RF short
- 143, 143A, 143B: dummy load
- 150: controller
- 160: printed-circuit board
- 161: branch-line coupler
- 162: circular patch antenna
- 200, 200A, 200B: field applicator
- 230: slot for first slot antenna
- 231: slot for second slot antenna
- 260: printed-circuit board
- 261: substrate-integrated waveguide 3dB hybrid coupler
- 262: via
- 263: metal layer
- 300: field applicator

## Claims

1. A solid-state cooking apparatus (10), comprising:
a cooking cavity (11);
a power amplifier system (110; 110A, 110B) for generating a radiofrequency 'RF' signal;
a field applicator (100; 200; 200A, 200B; 300) configured to provide an electromagnetic wave into the cooking cavity based on the generated RF signal, said field applicator comprising:
a splitting element for splitting the generated radiofrequency signal into a first signal and a second signal;
a first antenna element (130) for emitting a first wave based on the first signal into the cooking cavity;
a second antenna element (131) for emitting a second wave based on the second signal into the cooking cavity;
**characterized in that** the splitting element comprises a quadrature coupler (120; 161; 261) having an input port (1) connected to the power amplifier system, an isolated port (2) connected to a predefined load, a first output port (3) connected to the first antenna element, and a second output port (4) connected to the second antenna element;
**and in that** the solid-state cooking apparatus is operable in at least one of a first mode and second mode, wherein, in the first mode, the predefined load equals an RF short (142) or an RF open (141), and, in the second mode, the predefined load equals a dummy load (143; 143A, 143B) configured to dissipate the signal received at the isolated port of the quadrature coupler.

2. The solid-state cooking apparatus according to claim 1,
wherein the first and second waves are each linearly polarized electromagnetic waves, said first and second linearly polarized electromagnetic waves together forming, in the cooking cavity, a circularly or elliptically polarized electromagnetic wave; and/or
wherein the quadrature hybrid coupler comprises a 3dB hybrid coupler, and/or
wherein the RF short or RF open is configured to reflect the signal received from the isolated port of the quadrature coupler back into the quadrature coupler via the isolated port.

3. The solid-state cooking apparatus according to any of the previous claims, further comprising a switching unit (140) that connects one of the RF short, the RF open, or the dummy load to the isolated port of the quadrature coupler.

4. The solid-state cooking apparatus according to claim 3, further comprising a controller (150) for controlling the switching unit in dependence of a desired operating mode of the solid-state cooking apparatus.

5. The solid-state cooking apparatus according to claim 3 or 4, further comprising a power estimating system comprising one or more power estimating units (P) for estimating an amount of power that:
is reflected back from the cooking cavity and received at the first and/or second output port; and/or
is dissipated in or reflected by the predefined load; and/or
is outputted by the power amplifier system;
wherein the controller is configured to control the switching unit based on the estimated power(s).

6. The solid-state cooking apparatus according to claim 5,
wherein the controller is configured to switch the operating mode from the first mode to the second mode when the power reflected back from the cooking cavity and received at the first and/or second output ports and/or the power reflected by the predefined load exceeds a first threshold; and/or
wherein the controller is configured to switch the operating mode from the second mode to the first mode when power reflected back from the cooking cavity and received at the first and/or second output ports and/or the power reflected by the predefined load is below a second threshold; and/or
wherein each of the power estimating units is arranged between the first output port and the first antenna element, or between the second output port and the second antenna element, or between the isolated port and the predefined load; and/or
wherein at least one power estimating unit is configured to determine a power dissipated in the dummy load, said at least one power estimating unit comprising a current or voltage meter coupled to the dummy load;
wherein the power estimating units preferably each comprise a directional coupler.

7. The solid-state cooking apparatus according to any of the claims 3-6, wherein at least one of the switching unit, the controller, and the power estimating units are comprised in the field applicator.

8. The solid-state cooking apparatus according to any of the previous claims, including a double input circular polarization antenna, in which the first and second antenna elements are comprised, or wherein the first and second antenna elements are mutually orthogonal arranged antennas such as dipole antennas, folded dipole antennas, bowtie dipole antennas, loop antennas, slot antennas (230, 231), patch arrays, waveguides with orthogonal probes, and spiral antennas.

9. The solid-state cooking apparatus according to any of the previous claims, wherein the first and second antenna elements and the splitter are realized using substrate integrated waveguide technology.

10. The solid- state cooking apparatus according to claim 9, the field applicator (300) comprising:
a dielectric substrate (260) covered on opposite sides with a conductive layer, such as a metal layer (263);
a plurality of vias (262) extending through the substrate and electrically connecting the conductive layers on the opposite sides;
wherein the plurality of vias and the conductive layers define the splitting element and the first and second antenna element;
wherein the power amplifier system preferably comprises a RF power amplifier package in which a RF power amplifier is accommodated or a semiconductor die on which a RF power amplifier is realized, wherein the RF power amplifier package or the semiconductor die is arranged on one of the opposite sides of the dielectric substrate.

11. The solid-state cooking apparatus according to any of the previous claims, wherein the power amplifier system is integrated into and/or arranged on the field applicator, and/or wherein the field applicator at least partially extends in the cooking cavity.

12. The solid-state cooking apparatus according to any of the previous claims in so far as depending on claim 2, comprising:
a further power amplifier system for generating a further radiofrequency 'RF' signal;
a further field applicator configured to provide a further electromagnetic wave into the cooking cavity based on the generated further RF signal;
wherein the further power amplifier system and further field applicator are configured to provide a further circularly or elliptically polarized electromagnetic wave into the cooking cavity that has a polarity that is opposite to the polarity of said circularly or elliptically polarized electromagnetic wave.

13. The solid-state cooking apparatus according to claim 12, wherein the further field applicator comprises:
a further splitting element for splitting the generated further radiofrequency signal into a third signal and a fourth signal;
a third antenna element for emitting a third wave based on the third signal into the cooking cavity;
a fourth antenna element for emitting a fourth wave based on the fourth signal into the cooking cavity;
wherein the further splitting element comprises a further quadrature coupler having an input port connected to the further power amplifier system, an isolated port connected to a further predefined load, a first output port connected to the third antenna element, and a second output port connected to the fourth antenna element;
wherein, in the first mode, the predefined load equals an RF short or an RF open, and, in the second mode, the predefined load equals a dummy load configured to dissipate the signal received at the isolated port of the further quadrature coupler;
wherein the third and fourth waves are each linearly polarized electromagnetic waves, said third and fourth linearly polarized electromagnetic waves together forming, in the cooking cavity, said further circularly or elliptically polarized electromagnetic wave.

14. The solid-state cooking apparatus according to claim 12 or 13, further comprising a further switching unit that connects one of the RF short, the RF open, or the dummy load to the isolated port of the further quadrature coupler, said further switching unit being controlled by the controller; and/or
wherein at least one of the further field applicator and the further power amplifier system is identical to said field applicator and said power amplifier system, respectively; and/or
wherein the field applicator and further field applicator are adjacently arranged.

15. A field applicator (100; 200; 200A, 200B; 300) configured to provide an electromagnetic wave into a cooking cavity of a solid-state cooking device based on a generated RF signal, said solid-state cooking device comprising a power amplifier system (110; 110A, 110B) for generating said radiofrequency 'RF' signal, said field applicator comprising:
a splitting element for splitting the generated radiofrequency signal into a first signal and a second signal;
a first antenna element (130) for emitting a first wave based on the first signal into the cooking cavity;
a second antenna element (131) for emitting a second wave based on the second signal into the cooking cavity;
**characterized in that** the splitting element comprises a quadrature coupler (120; 161; 261) having an input port (1) connectable to the power amplifier system, an isolated port (2) connected to a predefined load, a first output port (3) connected to the first antenna element, and a second output port (4) connected to the second antenna element;
**and in that** the field applicator comprises a switching unit (140) configured for connecting one of an RF short (142), an RF open (141), or a dummy load (143; 143A, 143B) to the isolated port of the quadrature coupler to allow the solid-state cooking apparatus to be operable in at least one of a first mode and second mode, wherein, in the first mode, the predefined load equals the RF short (142) or the RF open (141), and, in the second mode, the predefined load equals the dummy load (143; 143A, 143B) configured to dissipate the signal received at the isolated port of the quadrature coupler.

## Patentansprüche

1. Festkörperkochvorrichtung (10), die aufweist:
einen Garraum (11);
ein Leistungsverstärkersystem (110; 110A, 110B) zum Erzeugen eines Hochfrequenz-'HF'-Signals;
einen Feldapplikator (100; 200; 200A, 200B; 300), der ausgestaltet ist, um basierend auf den erzeugten HF-Signal eine elektromagnetische Welle im Garraum vorzusehen,
wobei der Feldapplikator aufweist:
ein Splitterelement, um das erzeugte Hochfrequenzsignal in ein erstes Signal und ein zweites Signal aufzuteilen;
ein erstes Antennenelement (130), um basierend auf dem ersten Signal eine erste Welle in den Garraum auszustrahlen;
ein zweites Antennenelement (131), um basierend auf dem zweiten Signal eine zweite Welle in den Garraum auszustrahlen;
**dadurch gekennzeichnet, dass**
das Splitterelement einen Quadraturkoppler (120; 161; 261) mit einem Eingangsanschluss (1) aufweist, der mit dem Leistungsverstärkersystem verbunden ist,
einen isolierten Anschluss (2), der mit einer bestimmten Last verbunden ist, einen ersten Ausgangsanschluss (3), der mit dem ersten Antennenelement verbunden ist, und
einen zweiten Ausgangsanschluss (4), der mit dem zweiten Antennenelement verbunden ist;
und darin, dass
die Festkörperkochvorrichtung in wenigstens einem von einem ersten Modus und
einem zweiten Modus betreibbar ist, wobei im ersten Modus die vordefinierte Last HF-Kurz (142) oder HF-Offen (141) entspricht, und im zweiten Modus die vordefinierte Last einer Dummy-Last (143; 143A, 143B) entspricht, die ausgestaltet ist, das am isolierten Anschluss des Quadraturkopplers empfangene Signal zu dissipieren.

2. Festkörperkochvorrichtung nach Anspruch 1,
wobei die ersten und zweiten Wellen jeweils linear polarisierte elektromagnetische Wellen sind, die ersten und zweiten linear polarisierten elektromagnetischen Wellen zusammen im Garraum eine kreisförmig oder elliptisch polarisierte elektromagnetische Welle bilden; und/oder
wobei der Quadratur-Hybridkoppler einen 3dB-Hybridkoppler aufweist und/oder wobei der HF-Kurz oder der HF-Offen ausgestaltet ist/sind, das vom isolierten Anschluss des Quadraturkopplers empfangene Signal über den isolierten Anschluss in den Quadraturkoppler zurückzureflektieren.

3. Festkörperkochvorrichtung nach einem der vorhergehenden Ansprüche, die weiterhin eine Schaltungseinheit (140) aufweist, die eines von HF-Kurz, HF-Offen oder der Dummy-Last mit dem isolierten Anschluss des Quadraturkopplers verbindet.

4. Festkörperkochvorrichtung nach Anspruch 3, die weiterhin eine Steuereinheit (150) aufweist, um die Schaltungseinheit abhängig von einem gewünschten Betriebsmodus der Festkörperkochvorrichtung zu steuern.

5. Festkörperkochvorrichtung nach Anspruch 3 der 4, die weiterhin ein Leistungsschätzsystem aufweist, das ein oder mehrere Leistungsschätzeinheiten (P) aufweist, um einen Leistungsbetrag zu schätzen, der:
aus dem Garraum zurückreflektiert wird und am ersten und/oder zweiten Ausgangsanschluss empfangen wird; und/oder
durch die vordefinierte Last dissipiert oder reflektiert wird; und/oder vom Leistungsverstärkersystem ausgegeben wird;
wobei die Steuereinheit ausgestaltet ist, die Schaltungseinheit basierend auf der/den geschätzten Leistung(en) zu steuern.

6. Festkörperkochvorrichtung nach Anspruch 5,
wobei die Steuereinheit ausgestaltet ist, den Betriebsmodus von dem ersten Modus in den zweiten Modus zu wechseln, wenn die aus dem Garraum zurückreflektierte und an den ersten und/oder zweiten Ausgangsanschlüssen empfangene Leistung und/oder die Leistung, die durch die vordefinierte Last reflektiert wird, einen ersten Grenzwert übersteigt; und/oder
wobei die Steuereinheit ausgestaltet ist, den Betriebsmodus von zweiten Modus in den ersten Modus zu wechseln, wenn die aus dem Garraum zurückreflektierte und an den ersten und/oder zweiten Ausgangsanschlüssen empfangene Leistung und/oder die Leistung, die durch die vordefinierte Last reflektiert wird, unter einem zweiten Grenzwert liegt; und/oder
wobei eine jede von den Leistungsschätzeinheiten zwischen dem ersten Ausgangsanschluss und dem ersten Antennenelement angeordnet ist oder zwischen dem zweiten Ausgangsanschluss und dem zweiten Antennenelement oder zwischen dem isolierten Anschluss und der vordefinierten Last; und/oder wobei wenigstens eine Leistungsschätzeinheit ausgestaltet ist, eine Leistung zu bestimmen, die in der Dummy-Last dissipiert wird, wobei wenigstens eine Leistungsschätzeinheit einen Leistungs- oder Spannungsmesser aufweist, der mit der Dummy-Last verbunden ist;
wobei die Leistungsschätzeinheiten vorzugsweise jeweils einen Richtkoppler aufweisen.

7. Festkörperkochvorrichtung nach einem der Ansprüche 3 bis 6, wobei wenigstens eine von der Schaltungseinheit, der Steuereinheit und den Leistungsschätzeinheiten im Feldapplikator enthalten ist.

8. Festkörperkochvorrichtung nach einem der vorhergehenden Ansprüche, die eine kreisförmige Doppeleingangs-Polarisationsantenne aufweist, in der die ersten und zweiten Antennenelemente enthalten sind, oder wobei die ersten und zweiten Antennenelemente zueinander orthogonal angeordnete Antennen sind, wie Dipolantennen, gefaltete Dipolantennen, Schmetterlingsdipolantennen, Rahmenantennen, Schlitzantennen (230, 231), Patch Arrays, Wellenleiter mit orthogonalen Sonden und Spiralantennen.

9. Festkörperkochvorrichtung nach einem der vorhergehenden Ansprüche, wobei die ersten und zweiten Antennenelemente und der Splitter mithilfe von einer in einem Substrat integrierten Wellenleitertechnologie verwirklicht werden.

10. Festkörperkochvorrichtung nach Anspruch 9, wobei der Feldapplikator (300) aufweist:
ein dielektrisches Substrat (62), das an gegenüberliegenden Seiten mit einer leitfähigen Schicht, wie einer Metallschicht (263), überzogen ist;
eine Vielzahl von Durchkontaktierungen (262), die durch das Substrat verlaufen und die leitfähigen Schichten an den gegenüberliegenden Seiten elektrisch verbinden;
wobei die Vielzahl der Durchkontaktierungen und die leitfähigen Schichten das Splitterelement und das erste und zweite Antennenelement definieren;
wobei das Leistungsverstärkersystem vorzugsweise ein HF-Leistungsverstärkungspaket aufweist, in dem ein HF-Leistungsverstärker aufgenommen ist oder ein Halbleiter-Die, auf dem ein HF-Leistungsverstärker realisiert ist, wobei das HF-Leistungsverstärkungspaket oder der Halbleiter-Die an einer von den gegenüberliegenden Seiten des dielektrischen Substrats angeordnet ist.

11. Festkörperkochvorrichtung nach einem der vorhergehenden Ansprüche, wobei das Leistungsverstärkersystem in den Feldapplikator integriert und/oder darauf angeordnet ist, und/oder wobei der Feldapplikator wenigstens teilweise in den Garraum hinein verläuft.

12. Festkörperkochvorrichtung nach einem der vorhergehenden Ansprüche, insoweit von Anspruch 2 abhängig, die aufweist:
ein weiteres Leistungsverstärkersystem, um ein weiteres Hochfrequenz-,HF'-Signal zu erzeugen;
einen weiteren Feldapplikator, der ausgestaltet ist, um eine weitere elektromagnetische Welle im Garraum basierend auf dem weiteren erzeugten HF-Signal vorzusehen;
wobei das weitere Leistungsverstärkersystem und der weitere Feldapplikator ausgestaltet sind, um eine weitere kreisförmig oder elliptisch polarisierte elektromagnetische Welle im Garraum vorzusehen, die eine Polarität aufweist, die entgegengesetzt zur Polarität der kreisförmig oder elliptisch polarisierten elektromagnetischen Welle ist.

13. Festkörperkochvorrichtung nach Anspruch 12, wobei der weitere Feldapplikator aufweist:
ein weiteres Splitterelement, um das weitere erzeugte Hochfrequenzsignal in ein drittes Signal und ein viertes Signal aufzuteilen;
ein drittes Antennenelement, um basierend auf dem dritten Signal eine dritte Welle in den Garraum auszustrahlen;
ein viertes Antennenelement, um basierend auf dem vierten Signal eine vierte Welle in den Garraum auszustrahlen;
wobei das weitere Splitterelement einen weiteren Quadraturkoppler mit einem Eingangsanschluss aufweist, der mit dem weiteren Leistungsverstärkersystem verbunden ist, einen isolierten Anschluss, der mit einer weiteren bestimmten Last verbunden ist, einen ersten Ausgangsanschluss, der mit dem dritten Antennenelement verbunden ist, und einen zweiten Ausgangsanschluss, der mit dem vierten Antennenelement verbunden ist;
wobei im ersten Modus die vordefinierte Last HF-Kurz oder HF-Offen entspricht und im zweiten Modus die vordefinierte Last einer Dummy-Last entspricht, die ausgestaltet ist, das am isolierten Anschluss des weiteren Quadraturkopplers empfangene Signal zu dissipieren;
wobei die dritten und vierten Wellen jeweils linear polarisierte elektromagnetische Wellen sind, die dritten und vierten linear polarisierten elektromagnetischen Wellen zusammen im Garraum die weitere kreisförmig oder elliptisch polarisierte elektromagnetische Welle bilden.

14. Festkörperkochvorrichtung nach Anspruch 12 oder 13, die weiterhin eine weitere Schaltungseinheit aufweist, die eines von HF-Kurz, HF-Offen oder der Dummy-Last mit dem isolierten Anschluss des weiteren Quadraturkopplers verbindet, wobei die weitere Schaltungseinheit durch die Steuereinheit gesteuert wird; und/oder
wobei wenigstens eines von dem weiteren Feldapplikator und dem weiteren Leistungsverstärkersystem jeweils mit dem Feldapplikator und dem Leistungsverstärkersystem identisch ist; und/oder
wobei der Feldapplikator und der weitere Feldapplikator nebeneinander angeordnet sind.

15. Feldapplikator (100; 200; 200A, 200B; 300), der ausgestaltet ist, um eine elektromagnetische Welle in einem Garraum einer Festkörperkochvorrichtung basierend auf einem erzeugten HF-Signal vorzusehen, wobei die Festkörperkochvorrichtung ein Leistungsverstärkersystem (110; 110A, 110B) aufweist, um das Funkfrequenz-'HF'-Signal zu erzeugen, wobei der Feldapplikator aufweist:
ein Splitterelement, um das erzeugte Hochfrequenzsignal in ein erstes Signal und ein zweites Signal aufzuteilen;
ein erstes Antennenelement (130), um basierend auf dem ersten Signal eine erste Welle in den Garraum auszustrahlen;
ein zweites Antennenelement (131), um basierend auf dem zweiten Signal eine zweite Welle in den Garraum auszustrahlen;
**dadurch gekennzeichnet, dass**
das Splitterelement einen Quadraturkoppler (120; 161; 261) mit einem Eingangsanschluss (1) aufweist, der mit dem Leistungsverstärkersystem verbindbar ist, einen isolierten Anschluss (2), der mit einer bestimmten Last verbunden ist, einen ersten Ausgangsanschluss (3), der mit dem ersten Antennenelement verbunden ist, und einen zweiten Ausgangsanschluss (4), der mit dem zweiten Antennenelement verbunden ist;
und darin, dass
der Feldapplikator eine Schaltungseinheit (140) aufweist, die ausgestaltet ist, um eines von HF-Kurz (142), HF-Offen (141) oder einer Dummy-Last (143; 143A, 143B) mit dem isolierten Anschluss des Quadraturkopplers zu verbinden, um der Festkörperkochvorrichtung zu ermöglichen, in wenigstens einem von einem ersten Modus und einem zweiten Modus betreibbar zu sein, wobei im ersten Modus die vordefinierte Last HF-Kurz (142) oder HF-Offen (141) entspricht, und im zweiten Modus die vordefinierte Last der Dummy-Last (143; 143A, 143B) entspricht, die ausgestaltet ist, um das am isolierten Anschluss des Quadraturkopplers empfangene Signal zu dissipieren.

## Revendications

1. Dispositif de cuisson à semi-conducteur (10), comprenant :
une cavité de cuisson (11) ;
un dispositif d'amplification de puissance (110 ; 110A, 110B) destiné à produire un signal de radiofréquence "RF" ;
un élément d'application de champ (100 ; 200 ; 200A, 200B ; 300) configuré de manière à délivrer une onde électromagnétique dans la cavité de cuisson sur la base du signal RF produit, ledit élément d'application de champ comprenant :
un élément de séparation destiné à séparer le signal de radiofréquence produit en un premier signal et un deuxième signal ;
un premier élément d'antenne (130) destiné à émettre une première onde sur la base du premier signal dans la cavité de cuisson ;
un deuxième élément d'antenne (131) destiné à émettre une deuxième onde sur la base du deuxième signal dans la cavité de cuisson ;
**caractérisé en ce que** l'élément de séparation comprend un coupleur en quadrature (120 ; 161 ; 261) comportant un port d'entrée (1) raccordé au dispositif d'amplification de puissance, un port isolé (2) raccordé à une charge prédéfinie, un premier port de sortie (3) raccordé au premier élément d'antenne, et un deuxième port de sortie (4) raccordé au deuxième élément d'antenne ;
et **en ce que** le dispositif de cuisson à semi-conducteur peut fonctionner dans au moins un premier mode et un second mode, dans lequel, dans le premier mode, la charge prédéfinie est égale à une charge RF en court-circuit (142) ou une charge RF en circuit ouvert (141) et, dans le second mode, la charge prédéfinie est égale à une charge fictive (143 ; 143A, 143B) configurée de manière à dissiper le signal reçu au niveau du port isolé du coupleur en quadrature.

2. Dispositif de cuisson à semi-conducteur selon la revendication 1,
dans lequel les première et deuxième ondes sont chacune des ondes électromagnétiques polarisées linéairement, lesdites première et deuxième ondes électromagnétiques polarisées linéairement formant ensemble, dans la cavité de cuisson, une onde électromagnétique polarisée de manière circulaire ou elliptique ; et/ou
dans lequel le coupleur hybride en quadrature comprend un coupleur hybride à 3dB, et/ou
dans lequel la charge RF en court-circuit ou RF ouverte est configurée de manière à réfléchir le signal reçu à partir du port isolé du coupleur en quadrature de nouveau vers le coupleur en quadrature par l'intermédiaire du port isolé.

3. Dispositif de cuisson à semi-conducteur selon l'une quelconque des revendications précédentes, comprenant, en outre, une unité de commutation (140) qui couple l'une de la charge RF en court-circuit, la charge RF ouverte ou de la charge fictive au port isolé du coupleur en quadrature.

4. Dispositif de cuisson à semi-conducteur selon la revendication 3, comprenant, en outre, une unité de commande (150) destinée à commander l'unité de commutation en fonction d'un mode de fonctionnement désiré du dispositif de cuisson à semi-conducteur.

5. Dispositif de cuisson à semi-conducteur selon la revendication 3 ou 4, comprenant, en outre, un dispositif d'estimation de puissance comprenant une ou plusieurs unités d'estimation de puissance (P) destinées à estimer un niveau de puissance qui :
est réfléchi à partir de la cavité de cuisson et reçu au niveau du premier et/ou deuxième port de sortie ; et/ou
est dissipé dans ou réfléchi par la charge prédéfinie ; et/ou
est délivré par le dispositif d'amplification de puissance ;
dans lequel l'unité de commande est configurée de manière à commander l'unité de commutation sur la base des puissances estimées.

6. Dispositif de cuisson à semi-conducteur selon la revendication 5,
dans lequel l'unité de commande est configurée de manière à commuter le mode de fonctionnement à partir du premier mode vers le second mode lorsque la puissance réfléchie à partir de la cavité de cuisson et reçue au niveau des premier et/ou deuxième ports de sortie et/ou la puissance réfléchie par la charge prédéfinie excède un premier seuil ; et/ou
dans lequel l'unité de commande est configurée de manière à commuter le mode de fonctionnement à partir du second mode vers le premier mode lorsque la puissance réfléchie à partir de la cavité de cuisson et reçue au niveau des premier et/ou deuxième ports de sortie et/ou la puissance réfléchie par la charge prédéfinie est inférieure à un second seuil ; et/ou
dans lequel chacune des unités d'estimation de puissance est agencée entre le premier port de sortie et le premier élément d'antenne, ou entre le deuxième port de sortie et le deuxième élément d'antenne, ou entre le port isolé et la charge prédéfinie ; et/ou
dans lequel au moins une unité d'estimation de puissance est configurée de manière à déterminer une puissance dissipée dans la charge fictive, ladite au moins une unité d'estimation de puissance comprenant un dispositif de mesure de courant ou de tension couplé à la charge fictive ;
dans lequel les unités d'estimation de puissance comprennent chacune de préférence un coupleur directionnel.

7. Dispositif de cuisson à semi-conducteur selon l'une quelconque des revendications 3 à 6, dans lequel au moins l'une de l'unité de commutation, l'unité de commande et des unités d'estimation de puissance sont contenues dans l'élément d'application de champ.

8. Dispositif de cuisson à semi-conducteur selon l'une quelconque des revendications précédentes, comportant une antenne à polarisation circulaire à double entrées, dans laquelle les premier et second éléments d'antenne sont contenus, ou dans lequel les premier et second éléments d'antenne sont des antennes agencées de manière mutuellement orthogonale telles que des antennes dipôles, des antennes à dipôle repliés, des antennes à dipôle type bow-tie, des antennes en boucle, des antennes en fente (230, 231), des antennes imprimées, des guides d'ondes avec des sondes orthogonales et des antennes en spirale.

9. Dispositif de cuisson à semi-conducteur selon l'une quelconque des revendications précédentes, dans lequel les premier et second éléments d'antenne et le séparateur sont réalisés en utilisant une technologie de guide d'ondes intégré sur substrat.

10. Dispositif de cuisson à semi-conducteur selon la revendication 9, l'élément d'application de champ (300) comprenant :
un substrat diélectrique (260) recouvert sur des côtés opposés par une couche conductrice, telle qu'une couche métallique (263) ;
une pluralité de circuits (262) s'étendant à travers le substrat et reliant électriquement les couches conductrices sur les côtés opposés ;
dans lequel la pluralité de circuits et les couches conductrices définissent l'élément de séparation et les premier et second éléments d'antenne ;
dans lequel le dispositif d'amplification de puissance comprend, de préférence, un boîtier d'amplificateur de puissance RF dans lequel un amplificateur de puissance RF est reçu ou une plaquette semi-conductrice sur laquelle un amplificateur de puissance RF est réalisé, dans lequel le boîtier d'amplificateur de puissance RF ou la plaquette semi-conductrice est agencé sur l'un des côtés opposés du substrat diélectrique.

11. Dispositif de cuisson à semi-conducteur selon l'une quelconque des revendications précédentes, dans lequel le dispositif d'amplification de puissance est intégré dans l'élément d'application de champ et/ou agencé sur ce dernier, et/ou dans lequel l'élément d'application de champ s'étend au moins partiellement dans la cavité de cuisson.

12. Dispositif de cuisson à semi-conducteur selon l'une quelconque des revendications précédentes lorsqu'elle dépend de la revendication 2, comprenant :
un dispositif d'amplification de puissance supplémentaire destiné à produire un signal de radiofréquence "RF" supplémentaire ;
un élément d'application de champ supplémentaire configuré de manière à délivrer une onde électromagnétique supplémentaire dans la cavité de cuisson sur la base du signal RF supplémentaire produit ;
dans lequel le dispositif d'amplification de puissance supplémentaire et l'élément d'application de champ supplémentaire sont configurés de manière à produire une onde électromagnétique polarisée de manière circulaire ou elliptique supplémentaire dans la cavité de cuisson qui présente une polarité qui est opposée à la polarité de ladite onde électromagnétique polarisée de manière circulaire ou elliptique.

13. Dispositif de cuisson à semi-conducteur selon la revendication 12, dans lequel l'élément d'application de champ supplémentaire comprend :
un élément de séparation supplémentaire destiné à séparer le signal de radiofréquence supplémentaire en un troisième signal et un quatrième signal ;
un troisième élément d'antenne destiné à émettre une troisième onde sur la base du troisième signal dans la cavité de cuisson ;
un quatrième élément d'antenne destiné à émettre une quatrième onde sur la base du quatrième signal dans la cavité de cuisson ;
dans lequel l'élément de séparation supplémentaire comprend un autre coupleur en quadrature comportant un port d'entrée raccordé au dispositif d'amplification de puissance supplémentaire, un port isolé raccordé à une charge prédéfinie supplémentaire, un premier port de sortie raccordé au troisième élément d'antenne, et un deuxième port de sortie raccordé au quatrième élément d'antenne ;
dans lequel, dans le premier mode, la charge prédéfinie est égale à une charge RF en court-circuit ou une charge RF ouverte et, dans le second mode, la charge prédéfinie est égale à une charge fictive configurée de manière à dissiper le signal reçu au niveau du port isolé du coupleur en quadrature supplémentaire ;
dans lequel les troisième et quatrièmes ondes sont chacune des ondes électromagnétiques polarisées de manière linéaire, lesdites troisième et quatrième ondes électromagnétiques polarisées de manière linéaire formant ensemble, dans la cavité de cuisson, ladite onde électromagnétique polarisée de manière circulaire ou elliptique supplémentaire.

14. Dispositif de cuisson à semi-conducteur selon la revendication 12 ou 13, comprenant, en outre, une unité de commutation supplémentaire qui raccorde l'une des charges RF en court-circuit, RF ouverte ou la charge fictive au port isolé du coupleur en quadrature supplémentaire, ladite unité de commutation supplémentaire étant commandée par l'unité de commande ; et/ou
dans lequel au moins l'un de l'élément d'application de champ supplémentaire et du dispositif d'amplification de puissance supplémentaire est identique audit élément d'application de champ et respectivement audit dispositif d'amplification de puissance ; et/ou
dans lequel l'élément d'application de champ et l'élément d'application de champ supplémentaire sont agencés de manière adjacente.

15. Dispositif d'application de champ (100 ; 200 ; 200A, 200B ; 300) configuré de manière à produire une onde électromagnétique dans une cavité de cuisson dans un dispositif de cuisson à semi-conducteur sur la base d'un signal RF produit, ledit dispositif de cuisson à semi-conducteur comprenant un dispositif d'amplification de puissance (110 ; 110A, 110B) destiné à produire ledit signal de radiofréquence "RF", ledit élément d'application de champ comprenant :
un élément de séparation destiné à séparer le signal à radiofréquence produit en un premier signal et un deuxième signal ;
un premier élément d'antenne (130) destiné à émettre une première onde sur la base du premier signal dans la cavité de cuisson ;
un second élément d'antenne (131) destiné à émettre une deuxième onde sur la base du deuxième signal dans la cavité de cuisson ;
**caractérisé en ce que** l'élément de séparation comprend un coupleur en quadrature (120 ; 161 ; 261) comportant un port d'entrée (1) pouvant être raccordé au dispositif d'amplification de puissance, un port isolé (2) raccordé à une charge prédéfinie, un premier port de sortie (3) raccordé au premier élément d'antenne, et un deuxième port de sortie (4) raccordé au deuxième élément d'antenne ;
et **en ce que** l'élément d'application de champ comprend une unité de commutation (140) configurée de manière à raccorder l'une d'une charge RF en court-circuit (142), d'une charge RF ouverte (141) ou d'une charge fictive (143 ; 143A, 143B) sur le port isolé du coupleur en quadrature afin de permettre l'utilisation du dispositif de cuisson à semi-conducteur dans au moins l'un d'un premier mode et d'un second mode, dans lequel, dans le premier mode, la charge prédéfinie est égale à la charge RF en court-circuit (142) ou la charge RF ouverte (141) et, dans le second mode, la charge prédéfinie est égale à la charge fictive (143 ; 143A, 143B) configurée de manière à dissiper le signal reçu au niveau du port isolé du coupleur en quadrature.
